# EUROPÄISCHE PATENTSCHRIFT

(11) **EP 4 118 496 B1**
(45) Veröffentlichungstag und Bekanntmachung des Hinweises auf die Patenterteilung: **07.02.2024**
(21) Anmeldenummer: 21725033.1
(22) Anmeldetag: 21.04.2021
(51) Int. Cl.: G05B 17/02

(54) **VERFAHREN UND SYSTEME ZUM BEREITSTELLEN EINES SIMULATIONSMODELLS EINER ELEKTRISCHEN ROTATORISCHEN MASCHINE**
METHOD AND SYSTEMS FOR PROVIDING A SIMULATION MODEL OF AN ELECTRIC ROTARY MACHINE
PROCÉDÉ ET SYSTÈMES DE FOURNITURE D'UN MODÈLE DE SIMULATION D'UNE MACHINE ÉLECTRIQUE ROTATIVE

(30) Priorität: 08.05.2020 EP 20173646
(43) Veröffentlichungstag der Anmeldung: 18.01.2023
(60) Teilanmeldung: 23212707.6
(73) Patentinhaber: Siemens Aktiengesellschaft, 80333 München (DE)
(72) Erfinder: DEEG, Christian, 90518 Altdorf (DE)
(74) Vertreter: Siemens Patent Attorneys
(86) Internationale Anmeldenummer: PCT/EP2021/060340
(87) Internationale Veröffentlichungsnummer: WO 2021/224003

(56) Entgegenhaltungen:
- EP-A1- 3 322 088
- CN-A- 102 368 672
- CN-A- 110 007 232

## Beschreibung

Die Erfindung betrifft ein Verfahren zum Anbinden von einer elektrischen rotatorischen Maschine an eine Plattform gemäß Anspruch 1, vorzugsweise eine Software-Plattform, insbesondere eine Cloud-Plattform und ein Verfahren zur Betriebsverhaltensermittlung einer an einer Betriebsspannung angeschlossenen und boi an einer Plattform angebundenen elektrischen rotatorischen Maschine gemäß Anspruch 12. Darüber hinaus betrifft die Erfindung eine Anordnung zur Betriebsverhaltensermittlung einer an einer Betriebsspannung angeschlossenen elektrischen rotatorischen Maschine gemäß Anspruch 14, wobei die Anordnung eine Sensorvorrichtung und eine Recheneinrichtung umfasst.

Des Weiteren ist ein computerimplementiertes Verfahren zum Bereitstellen einer trainierten Funktion offenbart.

Außerdem ist ein computerimplementiertes Verfahren zum Bereitstellen eines Simulationsmodelles einer elektrischen rotatorischen Maschine unter Verwendung der vorgenannten trainierten Funktion offenbart, wobei das Simulationsmodell durch Parameterwerte festgelegt wird.

Darüber hinaus sind Computerprogramme offenbart, die entsprechende Befehle umfassen und bei der Ausführung des entsprechenden Programms durch einen Computer diesen dazu veranlassen, das eine oder/und das andere vorgenannte Verfahren auszuführen.

Obendrein ist eine Sensorvorrichtung mit einem computerlesbaren Medium offenbart, das ein weiteres Simulationsmodell aufweist, welches auf dem vorgenannten Simulationsmodell basiert.

Des Weiteren ist ein Datenträgersignal offenbart, das das vorgenannte Simulationsmodell und/oder das(die) vorgenannte(n) Computerprogramm(e) überträgt.

Onboarding von neuen Assets im Kontext einer immer weiter fortschreitenden Digitalisierung der Industrie stellt einen wichtigen Aspekt dar. Bei den Feldgeräten, Maschinen, Software etc. spricht man i.A. von Assets auf der Ebene des Anlageteils.

Bei Digitalisierung älterer Industrieanlagen stößt man oft auf das Problem, dass über die Maschinen, z.B. über elektrische rotatorische Maschinen, insbesondere über Asynchronmaschinen, beispielsweise Asynchronmotoren und -generatoren, in der Anlage verfügbare Informationen nicht ausreichen, um ein ausreichend genaues Simulationsmodell der Maschine zu erstellen und z.B. das Onboarding durchzuführen oder Betriebspunkte der Maschinen zu bestimmen.

Sogar wenn eine Ersatzschaltung (ein Simulationsmodell) eines Asynchronmotors bekannt ist ("Greenfield"), ist es oft schwer, sein Betriebsverhalten zu ermitteln. Eine mögliche Lösung dieses "Greenfield"-Problems wird in der EP 20 173 618.8 der Anmelderin vorgeschlagen.

Oft sind dazu aufwändige Messungen mittels teurer Sensoren notwendig.

Bei vielen Motoren z.B. aus älteren Baureihen stehen nicht selten noch weniger Informationen zur Verfügung. Die Informationen beschränken sich oft lediglich auf Daten, die auf einem Typenschild (Leistungsschild) zu finden sind ("Brownfield").

Ein möglicher Ansatz, um dem Problem zu begegnen und das Betriebsverhalten zu bestimmen, ist auf einfachere Methoden (z.B. lineare Interpolation) auszuweichen. Diese leiden allerdings unter deutlicher Ungenauigkeit und liefern zudem lediglich Aussagen zum Drehmoment, jedoch keine detaillierteren Angaben, wie z.B. Wirkungsgrad und Leistungsfaktor.

Ein weiterer Ansatz ist beispielsweise aus einer chinesischen Patentanmeldung CN 110007232 A bekannt, die ein Verfahren zur Vorhersage der Betriebseffizienz eines Käfigläufer-Asynchronmotors zum Gegenstand hat. Bei diesem Verfahren wird ein Simulationsmodell eines Käfigläufer-Asynchronmotors erstellt und unter Eingabe einer harmonischen Spannung in das Käfigläufer-Asynchronmotor-Simulationsmodell Simulationsdaten zu erhalten. Anschließend wird ein BP-Neuralnetz auf der Grundlage der Simulationsdaten trainiert, um ein BP-Neuralnetz-Vorhersagemodell zu erhalten. Um die Betriebseffizienz des aktuellen Käfigläufer-Asynchronmotors zu erhalten, werden sodann tatsächliche Betriebsdaten des aktuellen Käfigläufer-Asynchronmotors erfasst und in das BP-Neuralnetz-Vorhersagemodell eingegeben.

Außerdem ist aus einer chinesischen Patentanmeldung CN 102368672 A eine Simulationsvorrichtung und ein Simulationsverfahren für den Sanftanlauf eines Motors bekannt.

Des Weiteren ist aus einer europäischen Patentanmeldung EP 3 322 088 A1 ein Verfahren zum Überwachen des Betriebes einer elektrischen rotierenden Maschine bekannt. Um eine Durchführung des Verfahrens ohne konstruktive Änderungen an der elektrischen rotierenden Maschine zu ermöglichen, wird vorgeschlagen, dass außerhalb des Maschinengehäuses eine erste physikalische Größe des Stators der Maschine und eine zweite physikalische Größe des Rotors der Maschine gemessen wird, wobei aus der ersten physikalischen Größe und der zweiten physikalischen Größe mindestens eine Zustandsgröße der elektrischen rotierenden Maschine ermittelt wird.

Die Aufgabe der vorliegenden Erfindung kann somit darin gesehen werden, das ein Simulationsmodell einer elektrischen rotatorischen Maschine bereitzustellen und beispielsweise das Onboarding der elektrischen rotatorischen Maschinen anhand nur weniger zur Verfügung stehender Informationen zu ermöglichen und dabei auf aufwändige, teure Messungen, wie z.B. Messungen im Stillstand (z.B. Kaltwiderstandsmessung) in Verbindung mit rotierenden Messungen im Leerlauf (Spannungsreihe) und unter Last (Lastreihe) zu verzichten.

Die Aufgabe wird mit einem computerimplementierten Verfahren zum Bereitstellen eines Simulationsmodelles einer elektrischen rotatorischen Maschine der genannten Art, wobei das Simulationsmodell durch Parameterwerte festgelegt wird, erfindungsgemäß dadurch gelöst, dass
- Inputdaten erhalten werden, wobei die Inputdaten anhand der Maschine in einem nicht an einer Betriebsspannung angeschlossenen Zustand erhebbar und für die Maschine charakteristisch sind und eine Achshöhe, eine Polpaarzahl und Leistungsschildangaben der elektrischen rotatorischen Maschine umfassen,
- aus den Inputdaten unter Zuhilfenahme einer trainierten Funktion die Parameterwerte ermittelt werden, wobei die trainierte Funktion (F) nach einem nachstehend genannten Verfahren bereitgestellt wird, wobei die trainierte Funktion basierend auf der Achshöhe und der Polpaarzahl Verlust- und Streukoeffizienten ermittelt (S20), wobei
   die Parameterwerte aus den ermittelten Verlust- und Streukoeffizienten und Leistungsschildangaben (LSA) ermittelt werden,
- die ermittelten Parameterwerte bereitgestellt werden.

Im Zusammenhang mit der vorliegenden Erfindung wird unter dem Begriff "unter Zuhilfenahme" verstanden, dass die Ermittlung der Parameterwerte mehrere Teilschritte umfassen kann, wobei nicht bei jedem Teilschritt die trainierte Funktion F angewandt werden muss. Beispielsweise kann das Verfahren Teilschritte aufweisen, die mithilfe analytischer mathematischer Formeln durchgeführt werden können. Dies kann hinsichtlich der Rechenzeit vorteilhaft sein.

Im Zusammenhang mit der vorliegenden Erfindung wird unter dem Begriff "an eine Betriebsspannung angeschlossen" ein Zustand der elektrischen rotatorischen Maschine verstanden, in dem die Maschine an eine in Höhe und Frequenz festen (starres Netz) oder veränderlichen (Umrichterbetrieb) Betriebsspannung angeschlossen ist.

Vorzugsweise ist das Steuerverfahren des Umrichters bekannt, womit die unbekannte Umrichterausgangsspannung aus der sensorisch ermittelten Frequenz f₁ bestimmt werden kann.

Bei einer Ausführungsform kann vorgesehen sein, dass das Simulationsmodell als das Ersatzschaltbild ausgestaltet ist.

Es ist auch denkbar, dass das Simulationsmodell in Form zusammenhängender Gleichungen oder in tabellarischer Form vorliegt.

Bei einer Ausführungsform kann vorgesehen sein, dass die trainierte Funktion auf einem neuronalen Netz, auf einer Regression, vorzugsweise auf einer multivariaten Regression basiert ist.

Darüber hinaus kann mit Vorteil vorgesehen sein, dass die Inputdaten einer Plausibilitätsprüfung unterzogen werden.

Bei einer Ausführungsform kann vorgesehen sein, dass die Inputdaten aus Leistungsschildangaben bestehen.

Dabei kann vorgesehen sein, dass ein Teil der Parameterwerte durch die Leistungsschildangaben festgelegt wird. Hierdurch kann das Verfahren vereinfacht werden, indem Werte von bestimmten Parametern direkt aus den Leistungsschildangaben errechnet werden.

Es ist durchaus denkbar, dass die Inputdaten lediglich aus der Achshöhe und der Polpaarzahl bestehen. Mit solchen Inputdaten können gute Ergebnisse erzielt werden.

Der Vorteil einer multivariaten Regression und insbesondere auch der eines Neuronalen Netzes besteht darin, dass man die Trainingsinputdaten nicht beschränken und auch nicht gezielt aussuchen muss. Dies ist besonders vorteilhaft, wenn die Inputdaten mehr als zwei Eingangsgrößen (z.B. Achshöhe und Polpaarzahl), beispielsweise eine Vielzahl von Eingangsgrößen umfassen und das neuronale Netz mit den Eingangsgrößen versorgt wird, um die Simulationsmodellparameter zu bestimmen.

Außerdem wird die Aufgabe mit einem computerimplementierten Verfahren zum Bereitstellen einer trainierten Funktion der genannten Art erfindungsgemäß dadurch gelöst, dass
- Trainingsinputdaten erhalten werden, die für elektrische rotatorische Maschinen charakteristisch/repräsentativ sind und anhand der Maschinen in einem nicht an einer Betriebsspannung angeschlossenen Zustand erhebbar sind, wobei die Trainingsinputdaten Achshöhen und Polpaarzahlen umfassen,
- Trainingsoutputdaten erhalten werden, die für Parameterwerte repräsentativ sind und Verlust- und Streukoeffizienten umfassen, wobei die Parameterwerte Simulationsmodelle von den elektrischen rotatorischen Maschinen festlegen,
- eine Funktion basierend auf den Trainingsinputdaten und den Trainingsinputdaten trainiert wird,
- die trainierte Funktion bereitgestellt wird.

In einer Ausführungsform kann vorgesehen sein, dass ein Trainingsdatensatz, der Trainingsinput- und Trainingsoutputdaten umfasst, vorverarbeitet werden kann, bevor die Funktion auf dem Trainingsdatensatz trainiert wird. Die Vorverarbeitung kann beispielsweise das Bringen der Daten in eine relative und normierte Form umfassen.

Es kann zweckmäßig sein, wenn die Funktion auf einer Regression, vorzugsweise auf einer multivariaten Regression basiert ist.

Die Funktion kann auch auf einem neuronalen Netz basieren, sodass die vorgenannte trainierte Funktion ebenfalls auf einem neuronalen Netz basieren kann.

Die Aufgabe wird außerdem mit einem ersten Computerprogramm erfindungsgemäß dadurch gelöst, dass das erste Computerprogramm Befehle umfasst, die bei der Ausführung des Programms durch einen Computer diesen dazu veranlassen, die Simulationsmodellparameterwerte zu ermitteln.

Das Computerprogramm erhält also Inputdaten als Input und gibt Simulationsmodellparameterwerte als Output aus. Da das Simulationsmodell durch die Simulationsmodellparameterwerte festgelegt ist, kann gleichermaßen vom Bereitstellen eines Simulationsmodelles oder vom Bestimmen der Simulationsmodellparameterwerte gesprochen werden.

Die Aufgabe wird auch mit einem zweiten Computerprogramm erfindungsgemäß dadurch gelöst, dass das zweite Computerprogramm Befehle umfasst, die bei der Ausführung des Programms durch einen Computer diesen dazu veranlassen, die trainierte Funktion bereitzustellen.

Das erste und/oder das zweite Computerprogramm können/kann auf einem computerlesbaren Medium gespeichert sein oder mit einem Datenübertragungssignal, z.B. in einer kodierten Form, übertragen werden.

Obendrein wird die Aufgabe der Erfindung mit einem Verfahren zum Anbinden von einer elektrischen rotatorischen Maschine an eine Plattform, vorzugsweise eine Software-Plattform, insbesondere eine Cloud-Plattform der genannten Art erfindungsgemäß dadurch gelöst, dass
- anhand der Maschine in einem nicht an einer Betriebsspannung angeschlossenen Zustand Inputdaten erhoben werden, die eine Achshöhe, eine Polpaarzahl und Leistungsschildangaben der Maschine umfassen, wobei die Inputdaten für die Maschine charakteristisch sind und als Input für eine Konfigurationsanwendungssoftware eingegeben werden, wobei
- die Konfigurationsanwendungssoftware die Inputdaten an die Plattform überträgt, wobei die Plattform Befehle umfasst, die bewirken, dass das vorgenannte Verfahren durch die Plattform ausgeführt wird, um ein Simulationsmodell der elektrischen rotatorischen Maschine bereitzustellen, wobei
- vorzugsweise das Simulationsmodell an die Konfigurationsanwendungssoftware übermittelt wird, wobei die Konfigurationsanwendungssoftware das Simulationsmodell an eine an der Maschine angeordnete, vorzugsweise befestigte Sensorvorrichtung überträgt.

Des Weiteren wird die Aufgabe der vorliegenden Erfindung mit einem Verfahren zur Betriebsverhaltensermittlung einer an einer Betriebsspannung angeschlossenen und beispielsweise an einer Plattform angebundenen elektrischen rotatorischen Maschine erfindungsgemäß dadurch gelöst, dass
A) ein Streumagnetfeld außerhalb der Maschine erfasst wird,
B) aus dem erfassten Streumagnetfeld eine Schlupffrequenz f₂ und eine Synchronfrequenz bzw. Synchrondrehzahl f₁ berechnet werden,
C) aus der Schlupffrequenz f₂und der Synchronfrequenz bzw. Synchrondrehzahl f₁ ein Schlupf s berechnet wird,
D) ein Simulationsmodell nach dem vorgenannten Verfahren bereitgestellt wird,
E) anhand des Schlupfs s, der Synchronfrequenz f₁ und des bereitgestellten Simulationsmodelles Betriebsverhalten der Maschine und insbesondere ihr Betriebspunkt ermittelt wird.

Obendrein wird die Aufgabe der vorliegenden Erfindung mit einer Anordnung der genannten Art erfindungsgemäß dadurch gelöst, dass die Sensorvorrichtung dazu ausgebildet ist, ein Streumagnetfeld außerhalb der Maschine zu erfassen und aus dem erfassten Streumagnetfeld eine Schlupffrequenz f₂und eine Synchronfrequenz f₁ zu berechnen und diese an die Recheneinrichtung zu übermitteln, wobei auf der Recheneinrichtung ein gemäß dem vorgenannten Verfahren bereitgestelltes Simulationsmodell gespeichert ist und die Recheneinrichtung dazu konfiguriert ist, anhand der berechneten Schlupf- f₂und Synchronfrequenz f₁ einen Schlupf s und anschließend mittels des Simulationsmodelles das Betriebsverhalten der Maschine zu ermitteln.

Im Folgenden wird die Erfindung anhand der in den Figuren dargestellten Ausführungsbeispiele näher beschrieben und erläutert. Es zeigen:
- FIG 1: ein Flussdiagramm eines computerimplementierten Verfahrens zum Bereitstellen eines Ersatzschaltbildes,
- FIG 2 bis FIG 4: mögliche Ersatzschaltbilder,
- FIG 5: ein Flussdiagramm eines computerimplementierten Verfahrens zum Bereitstellen einer trainierten Funktion,
- FIG 6: eine industrielle IT-Umgebung, und
- FIG 7: ein Flussdiagramm eines Verfahrens zur Betriebsverhaltensermittlung einer elektrischen rotatorischen Maschine.

In den Ausführungsbeispielen und Figuren können gleiche oder gleich wirkende Elemente jeweils mit den gleichen Bezugszeichen versehen sein.

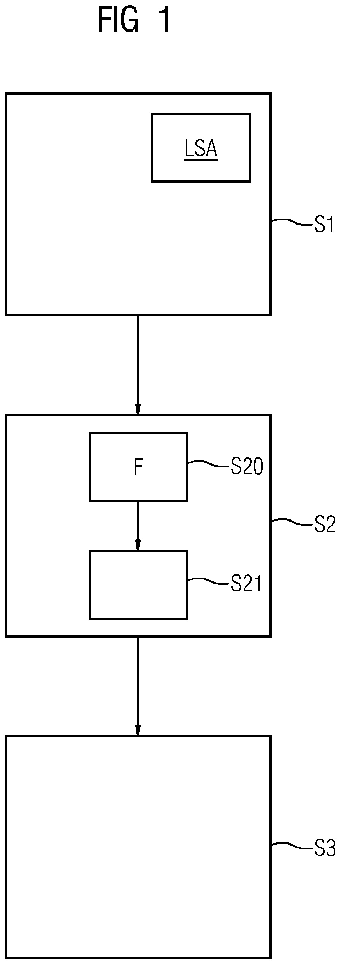

Zunächst wird auf FIG 1 Bezug genommen. In der FIG 1 ist eine Ausführungsform eines computerimplementierten Verfahrens zum Bereitstellen eines Simulationsmodells einer elektrischen rotatorischen Maschine 2 als ein Flussdiagramm dargestellt. Nachfolgend wird als Beispiel des Simulationsmodells Ersatzschaltbild EC1, EC2, EC3 betrachtet. Verwendung anderer Simulationsmodelle, wie z.B. Simulationsmodelle in Form zusammenhängender Gleichungen oder in tabellarischer Form ist ebenfalls möglich.

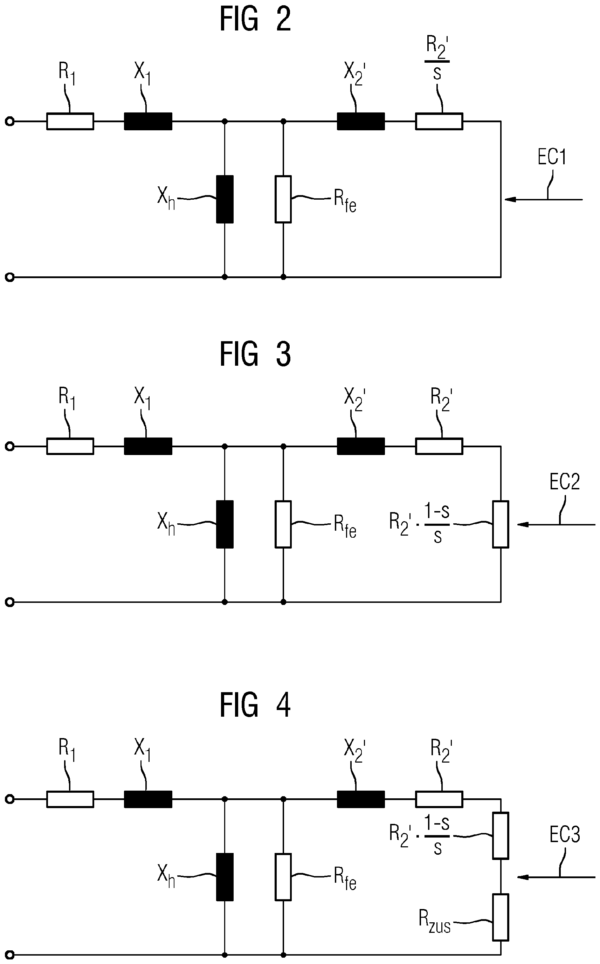

Das Ersatzschaltbild EC1, EC2, EC3 wird durch Werte vorbestimmter Parameter festgelegt. FIG 2 bis 4 zeigen beispielhaft verschiedene Ersatzschaltbilder EC1, EC2, EC3. FIG 2 betrifft ein T-Ersatzschaltbild EC1, FIG 3 - ein T-Ersatzschaltbild EC2 mit aufgetrenntem Läuferwiderstand, welches mit dem T-Ersatzschaltbild der FIG 2 gleichwertig ist und FIG 4 - ein erweitertes Ersatzschaltbild EC3 mit folgenden Parametern: Hauptinduktivität Xₕ (Hauptfluss), Ständer- X₁ und Läuferinduktivität X'₂ (Streuflüsse), Läuferwiderstand R'₂ (Rotorwicklungsverluste), Ständerwiderstand R₁ (Statorwicklungsverluste), R_{fe} (Eisenverluste) und R_{zus} (Zusatzverluste).

Ohne den Umfang der vorliegenden Offenbarung zu beschränken und der Einfachheit der Darstellung halber wird im Folgenden unter dem Begriff "Ersatzschaltbild" das erweiterte Ersatzschaltbild EC3 verstanden.

In einem Schritt S1 des Verfahrens werden Inputdaten erhalten. Die Inputdaten sind anhand der Maschine 2 in einem nicht an einer Betriebsspannung angeschlossenen Zustand erhebbar und für die Maschine 2 charakteristisch. Dabei können die Inputdaten beispielsweise über eine erste Schnittstelle in eine Rechenvorrichtung eingespeist werden, z.B. als Input in eine Konfigurations-App eingegeben werden. Die Inputdaten sind die Daten, die die Maschine 2 kennzeichnen. Die Inputdaten umfassen beispielsweise Leistungsschildangaben LSA - Herstellerangaben, Normangaben, regulatorische Angaben etc., die die Maschine im Bemessungspunkt (bei Last von 100%) charakterisieren. Weitere Inputdaten, die anhand der nicht angeschlossenen Maschine erhoben werden können, aber zum Beispiel nicht auf ihrem Leistungsschild angegeben werden müssen, sind zum Beispiel Polpaarzahl, Achshöhe etc.

Ferner kann das Verfahren eine Plausibilitätsprüfung der Inputdaten umfassen (hier nicht gezeigt). Dabei kann beispielsweise überprüft werden, ob Wirkungsgrad und Leistungsfaktor im Bemessungspunkt, wenn gegeben, zu einem hinreichend kleinen Fehler bei der Berechnung einer mechanischen Bemessungsleistung in Abhängigkeit von Bemessungsspannung und Bemessungsstrom führen.

In einem Schritt S2 werden aus den Inputdaten unter Zuhilfenahme einer trainierten Funktion F die Parameterwerte des Ersatzschaltbildes EC3 ermittelt.

Im Zusammenhang mit der vorliegenden Erfindung wird unter dem Begriff "unter Zuhilfenahme" verstanden, dass die Ermittlung der Parameterwerte mehrere Teilschritte umfassen kann, wobei nicht bei jedem Teilschritt die trainierte Funktion F angewandt werden muss.

FIG 1 zeigt eine Ausführungsform, bei der Schritt S2 zwei Teilschritte - einen ersten Teilschritt S20 und einen zweiten Teilschritt S21 - umfasst. Der erste Teilschritt S20 kann beispielsweise jener Schritt sein, bei dem die trainierte Funktion F auf zumindest einen Teil der Inputdaten angewandt wird. Dieser Teil der Inputdaten umfasst beispielsweise die Achshöhe und die Polpaarzahl der Maschine 2. Dabei kann die trainierte Funktion F aus dem zumindest einen Teil der Inputdaten beispielsweise Verlust- und Streukoeffizienten zur Bestimmung der Parameterwerte des Ersatzschaltbildes EC3 der Maschine 2 ermitteln.

Die trainierte Funktion F kann beispielsweise auf einer Regression, vorzugsweise auf einer multivariaten Regression basieren.

Anhand der in dem ersten Teilschritt S20 ermittelten Parameter, beispielsweise der Verlust- und der Streukoeffizienten und dem restlichen Teil der Inputdaten - den Leistungsschildangaben LSA - können in dem zweiten Teilschritt S21 die Parameterwerte der Ersatzschaltbildparameter beispielsweise über andere physikalische Größen ermittelt werden, vorzugsweise mithilfe vorbestimmter mathematischer Formel oder Formeln berechnet werden.

Eine nicht abschließende Liste der physikalischen Größen, die in Schritt S2, vorzugsweise in dem zweiten Teilschritt S21 ermittelt, vorzugsweise mithilfe vorbestimmter mathematischer Formel oder Formeln berechnet werden können, ist: Polpaarzahl, Synchrondrehzahl, Schlupf, Aufnahmeleistung, Zusatzverluste, einzelne Ständerwicklungs-, Eisen- und Reibungsverluste und ihre Summe, Ständerwiderstand, Gesamtblindleistung, maximal möglicher Streukoeffizient etc.

Beispielsweise können die Polpaarzahl, Synchrondrehzahl und Bemessungsschlupf aus Bemessungsfrequenz *f_{N}* und Bemessungsdrehzahl *n_{N},* die auf dem Typenschild angegeben sein können, bestimmt werden. Des Weiteren lässt sich eine elektrische Aufnahmeleistung im Bemessungspunkt (Betrieb als Motor) aus Strom, Spannung und Leistungsfaktor (jeweils im Bemessungspunkt) oder aus mechanischer Abgabeleistung und Wirkungsgrad (ebenfalls jeweils im Bemessungspunkt) berechnen.

Die Zusatzverluste können beispielsweise gemäß einem Standard oder einer Norm, z.B. gemäß einem Verfahren nach IEC60034-2-1 beziehungsweise EN60034-2-1 berechnet werden.

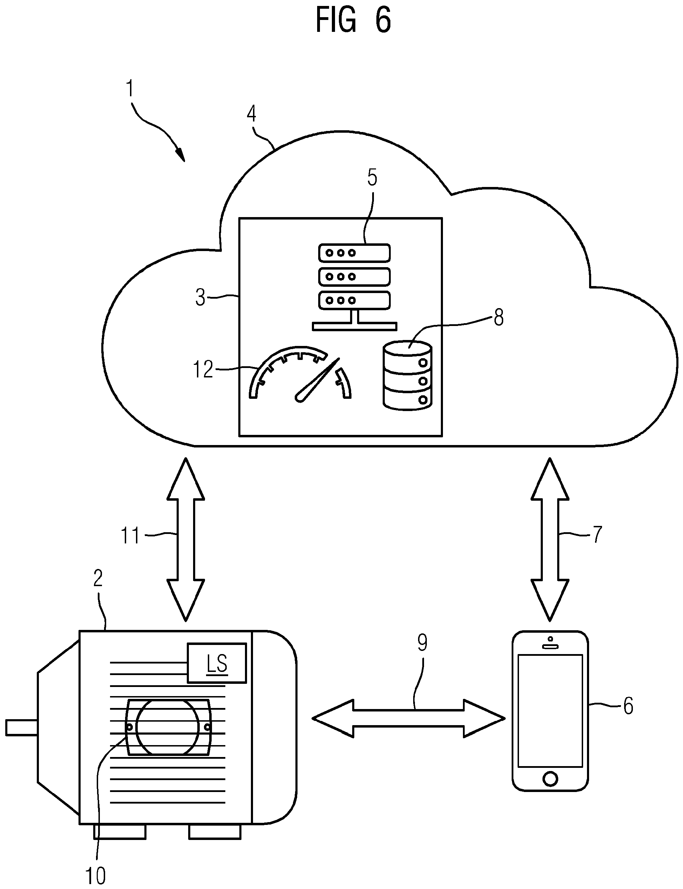

In einem weiteren Schritt S3 werden die ermittelten Parameterwerte - Hauptinduktivität Xₕ (Hauptfluss), Ständer- X₁ und Läuferinduktivität X'₂ (Streuflüsse), Läuferwiderstand R'₂ (Rotorwicklungsverluste), Ständerwiderstand R₁ (Statorwicklungsverluste), R_{fe} (Eisenverluste) und R_{zus} (Zusatzverluste) - bereitgestellt. Dies kann beispielsweise mittels Ausgabe über eine zweite Schnittstelle ausgeführt werden (siehe z.B. FIG 6). Beispielsweise kann das Ersatzschaltbild EC3 mit den ermittelten Parameterwerten durch Speichern der Parameter in einer Datenbank 8, beispielsweise in einer Cloud 4, hinterlegt werden.

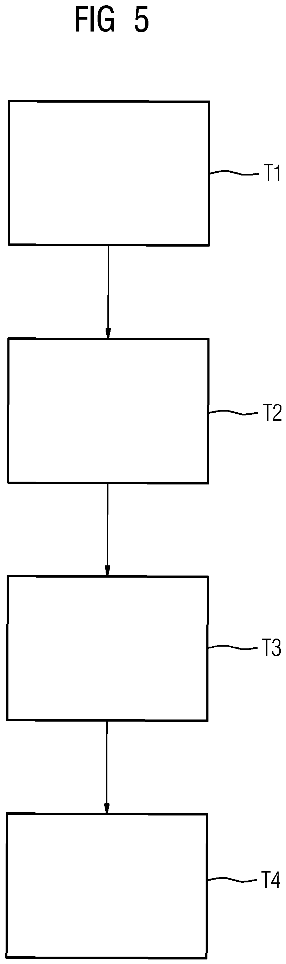

FIG 5 zeigt eine mögliche Ausführungsform eines computerimplementierten Verfahrens zum BereiLsLellen einer trainierten Funktion, beispielsweise der vorgenannten trainierten Funktion F.

In einem Schritt T1 werden Trainingsinputdaten, beispielsweise mittels einer ersten Trainingsschnittstelle erhalten. Trainingsinputdaten sind für elektrische rotatorische Maschinen charakteristisch beziehungsweise repräsentativ und anhand der Maschinen in einem nicht an einer Betriebsspannung angeschlossenen Zustand erhebbar. Die Trainingsinputdaten umfassen Achshöhen und Polpaarzahlen.

In einem Schritt T2 werden Trainingsoutputdaten, beispielsweise mittels der ersten Trainingsschnittstelle erhalten, die für Parameterwerte repräsentativ sind und Verlust- und Streukoeffizienten umfassen, wobei die Parameterwerte die Ersatzschaltbilder von den elektrischen rotatorischen Maschinen festlegen.

D.h. der Trainingsdatensatz umfasst Daten von jenen Maschinen, deren Ersatzschaltbildparameterwerte bereits bekannt sind. Dies können z.B. Daten von Asynchronmaschinen, z.B. Asynchronmotoren oder -generatoren, bekannter Typen sein.

Der Trainingsdatensatz, der Trainingsinput- und Trainingsoutputdaten umfasst, kann vorverarbeitet werden, bevor die Funktion auf dem Trainingsdatensatz trainiert wird. Die Vorverarbeitung kann beispielsweise das Bringen der Daten in eine relative und normierte Form umfassen.

In einem Schritt T3 wird eine Funktion basierend auf den Trainingsinputdaten und den Trainingsoutputdaten trainiert.

In einem Schritt T4 wird die trainierte Funktion F beispielsweise mittels einer zweiten Trainingsschnittstelle bereitgestellt.

Die Funktion kann beispielsweise auf einer Regression, vorzugsweise auf einer multivariaten Regression basiert sein.

Die Trainingsinputdaten können Achshöhen (z.B. 63 mm bis 450 mm), vorzugsweise Achshöhen und Polpaarzahlen (z.B. 2 bis 8) und die Trainingsoutputdaten Verlust- und Streukoeffizienten umfassen. Es versteht sich, dass das Verfahren auch für andere Achshöhen (z.B. kleiner 63 mm und größer 455 mm) und Polpaarzahlen funktioniert.

Der Trainingsdatensatz kann somit Daten von elektrischen rotatorischen Maschinen, z.B. von Asynchronmaschinen gleichen oder ähnlichen Typs umfassen, bei welchen eine Abhängigkeit der Ersatzschaltbildparameter von ihrer Achshöhe oder von ihrer Achshöhe und ihrer Polpaarzahl bekannt ist.

Die trainierte Funktion kann außerdem validiert werden. Dies kann z.B. in einem Belastungsbereich 50 bis 125% erfolgen.

Der Trainingsdatensatz kann Daten von 1000 bis 2000 Asynchronmaschinen verschiedener Typen umfassen.

Die Funktion kann auch auf einem neuronalen Netz basieren, sodass die vorgenannte trainierte Funktion F ebenfalls auf einem neuronalen Netz basieren kann.

Jedes der vorgenannten computerimplementierten Verfahren kann in Form von Befehlen eines Computerprogramms vorliegen, wobei die Befehle, wenn das Computerprogramm durch einen Computer oder im Allgemeinen durch ein Datenverarbeitungssystem ausgeführt wird, den Computer oder das Datenverarbeitungssystem dazu veranlassen, das entsprechende Verfahren auszuführen.

Das(die) Computerprogramm(e) kann(können) auf einem computerlesbaren Medium gespeichert werden oder mit einem Datenträgersignal übertragen werden. Dies trifft ebenfalls auf die Verfahrensprodukte, i.e. auf das Ersatzschaltbild EC1, EC2, EC3 mit den ermittelten Parameterwerten und auf die trainierte Funktion F zu, die auf einem computerlesbaren Medium gespeichert oder mit einem Datenträgersignal übertragen werden können.

FIG 6 zeigt eine industrielle IT-Umgebung 1, in der einer Ausführungsform des Verfahrens zum Anbinden bzw. für Onboarding von neuen Assets - hier von einer elektrischen rotatorischen Maschine 2 - an eine Plattform 3 ausgeführt werden kann. Die Plattform kann beispielsweise als eine Software-Plattform, und insbesondere als eine in einer Cloud 4 basierte Plattform 3 - eine Cloud-Plattform 3 - ausgebildet sein. Die Cloud kann beispielsweise als eine IoT-, insbesondere als eine IIoT-Cloud 4 ausgeführt sein.

Die Cloud-Plattform 3 kann eine oder mehrere Recheneinheiten umfassen. Die Cloud-Plattform 3 kann beispielsweise das vorgenannte Computerprogramm umfassen, mit welchem Parameterwerte für ein Ersatzschaltbild der Maschine 2 bereitgestellt werden können. Dieses Computerprogramm kann beispielsweise in der Cloud 4 auf einem Backend-Server 5 gespeichert sein.

In dem vorliegenden Beispiel wird davon ausgegangen, dass weder das Ersatzteilbild noch die Ersatzschaltbildparameter der Maschine 2 bekannt sind. Es kann angenommen werden, dass die Maschine 2 beispielsweise durch das erweiterte Ersatzschaltbild EC3 beschrieben wird. Die Parameterwerte für dieses Ersatzschaltbild können beispielsweise mithilfe der vorgenannten Ausführungsform des Verfahrens wie nachfolgend beschrieben ermittelt werden.

Wenn die Ersatzschaltbildparameter der Maschine 2 bekannt sind, kann die IT-Umgebung 1 zum Trainieren eine Funktion F, beispielsweise wie oben beschrieben verwendet werden. Zu diesem Zweck kann beispielsweise der Backend-Server 5 ein Computerprogramm mit den entsprechenden Befehlen aufweisen.

Zunächst werden anhand der Maschine 2, z.B. des Asynchronmotors oder -generators, in einem nicht an einer Betriebsspannung angeschlossenen Zustand Inputdaten erhoben, die für die Maschine 2 charakteristisch sind und als Input in eine Konfigurationsanwendungssoftware eingegeben werden können.

Dies kann beispielsweise durch einen Benutzer erfolgen, der beispielsweise zunächst die für das Asset, z.B. für die Maschine, insbesondere für den Asynchronmotor relevanten Daten sammelt, indem er/sie beispielsweise Angaben von einem Leistungsschild LS abliest, die Achshöhe des Asynchronmotors 2 misst. Darüber hinaus kann die Polpaarzahl aus den Leistungsschildangaben, beispielsweise mit dem oben beschriebenen Verfahren, berechnet werden.

Beim Einrichten des Asynchronmotors oder -generators 2 kann er/sie im Rahmen des sogenannten Onboardings die erhaltenen Inputdaten in eine Konfigurations-App auf einem mobilen Gerät 6, z.B. Smartphone/Handheld eingeben.

Die Konfiguration-App kann die Inputdaten über eine Datenverbindung 7, beispielsweise WLAN oder GSM-Mobilfunk, an die IoT-Cloud 4, insbesondere zum Backend-Server 5 übertragen.

Die Inputdaten können auch in einer Datenbank 8 gespeichert werden, wobei die Datenbank 8 als eine Datenbank der Cloud-Plattform 3 (hier gezeigt) oder auch als eine Cloud-Datenbank eines Dritten (hier nicht gezeigt) ausgeführt werden kann.

Das auf dem Backend-Server 5 gespeicherte Computerprogramm kann auf die Datenbank 8 zugreifen.

Das Computerprogramm greift anschließend auf die Inputdaten zu und erzeugt/ermittelt zu dem Asynchronmotor 2 das zugehörige Simulationsmodell EC3, d.h. die Parameterwerte.

Das Verfahren kann für jedes neue Asset wiederholt werden.

Anschließend kann in einem Zwischenschritt, der Informationsgehalt des Simulationsmodells aus Gründen der Informationssicherheit verringert werden. Dabei kann das erweiterte Ersatzschaltbild EC3 mit den ermittelten Parameterwerten in ein komprimiertes bzw. reduziertes Ersatzschaltbild umgewandelt werden.

Das reduzierte Ersatzschaltbild weist einen geringeren Informationsgehalt als das erweiterte Ersatzschaltbild. In dem reduzierten Ersatzschaltbild können Ersatzschaltbild Elemente zusammengefasst beziehungsweise gänzlich entfernt werden. Dabei wird bei der Berechnung auf dem IoT-Gerät der reduzierte Informationsgehalt zumindest teilweise wieder ergänzt, indem (plausible) Annahmen getroffen werden, die jedoch nur für den einzelnen Motor - und nicht notwendigerweise exakt - zutreffend sind. Daher können die Aussagen zum Betriebsverhalten sehr beschränkt sein und sich lediglich auf Drehmoment und Leistung beschränken.

Das Simulationsmodell - Ersatzschaltbild EC3 mit den ermittelten Parameterwerten - kann anschließend beispielsweise in der Plattform-Datenbank 8 oder auf dem Backend-Server 5 gespeichert werden, um - im weiteren Verlauf des Onboardings - für die Konfigurations-App abrufbar zu sein, oder ohne Zwischenspeichern an die Konfigurations-App übertragen werden.

Nachdem die Konfiguration-App über das Simulationsmodell verfügt, kann sie das Simulationsmodell über eine weitere, beispielsweise funkbasierte Datenverbindung 9, z.B. Bluetooth oder WLAN, an ein IoT-Gerät 10, das an dem Asynchronmotor 2 angeordnet vorzugsweise befestigt ist, übertragen.

Das IoT-Gerät 10 kann als eine Sensorvorrichtung ausgebildet sein, die dazu ausgebildet und konfiguriert ist, Sensordaten zu erzeugen und das Simulationsmodell (Ersatzschaltbild EC3 oder das reduzierte Ersatzschaltbild mit den ermittelten Parameterwerten) zu verwenden, um beispielsweise aus den Sensordaten mithilfe des Simulationsmodells Daten des aktuellen Motorbetriebspunktes bzw. Asset-KPIs (KPIs für Key Performance Indicators) zu berechnen. Hierzu können/kann in dem IoT-Gerät 10 eine Recheneinheit und/oder ein computerlesbares Speichermedium vorgesehen sein (hier nicht gezeigt).

Das IoT-Gerät 10 ist vorzugsweise an keine Maschinensensoren innerhalb (oder auch außerhalb) der Maschine 2 angebunden.

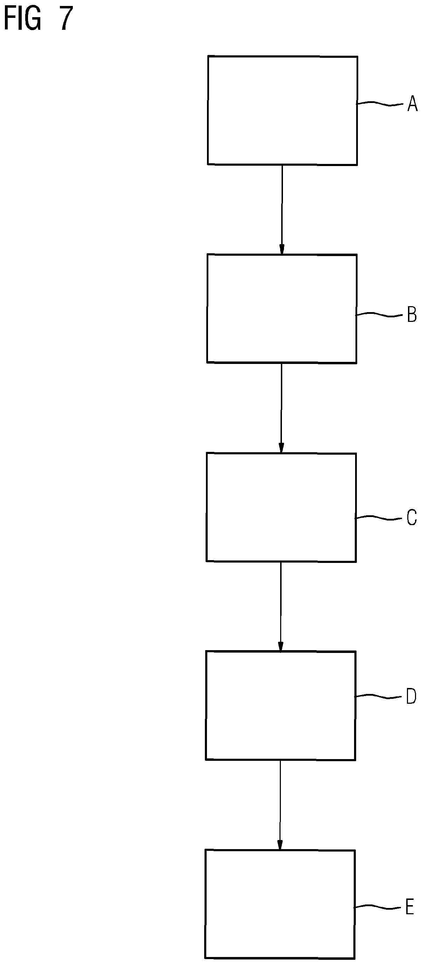

Für die hier beschriebene Betriebsverhaltensermittlung (siehe z.B. Beschreibung zu FIG 7) sind keine teuren und wartungsaufwändigen Sensoren notwendig, die beispielsweise Strom oder Spannung messen können. Daher ist das IoT-Gerät 10 sehr günstig und wartungsfreundlich. Dabei können/kann beispielsweise ein Drehmoment und/oder eine Leistung, z.B. mechanische Wellenleistung und/oder ein Leistungsfaktor und/oder ein Wirkungsgrad ermittelt werden.

Die berechneten Assets-KPIs (das Betriebsverhalten des Asynchronmotors 2) können über eine weitere vorzugsweise funkbasierte Datenverbindung 11, z.B. WLAN, beispielsweise in einstellbaren (Zeit-)Intervallen an die IoT-Cloud-Plattform 3 übermittelt werden. Dort können die Assets-KPIs einer weiteren IT-Verarbeitung unterzogen oder in der Datenbank 8 oder auf dem Backend-Server 5 abgespeichert werden. Weiterhin können die Assets-KPIs an einer beispielsweise im Frontend der IoT-Cloud-Plattform angeordneten Anzeigevorrichtung z.B. an einem Dashboard 12 angezeigt werden.

Die Datenverbindungen 7, 9, 11 sind vorzugsweise alle zweiseitig.

Bei einer (hier nicht gezeigten) Ausführungsform kann auf Übertragen des Simulationsmodells an das IoT-Gerät 10 verzichtet werden. In diesem Fall kann auch auf das vorgenannte Komprimieren des Ersatzschaltbildes verzichtet werden, wodurch bessere Ergebnisse erzielt werden können. Stattdessen kann die Berechnung der Asset-KPIs (des Betriebsverhaltens des Asynchronmotors oder -generators 2) in die IoT-Cloud-Plattform 3 verlagert werden.

FIG 7 zeigt ein Flussdiagramm einer Ausführungsform eines oben kursorisch thematisierten Verfahrens zur Betriebsverhaltensermittlung der Maschine 2, wenn sie in Betrieb genommen wird.

In einem Schritt A wird ein Streumagnetfeld außerhalb der Maschine 2 erfasst. In einem Schritt B werden aus dem erfassten Streumagnetfeld eine Schlupffrequenz f₂ und eine Synchronfrequenz f₁ berechnet. In einem Schritt C wird aus der Schlupffrequenz f₂ und der Synchronfrequenz f₁ ein Schlupf s berechnet. Dies kann beispielsweise mittels einer Signalverarbeitungssoftware erfolgen. In einem Schritt D wird, wie oben beschrieben, ein Ersatzschaltbild (die ermittelten Ersatzschaltbildparameterwerte) bereitgestellt (z.B. mittels einer Datenübertragung von dem mobilen Gerät 6). Die Bereitstellung des Ersatzschaltbildes mittels einer Datenübertragung von einem mobilen Gerät 6 findet vorzugsweise nicht während der Mess- bzw. Berechnungssequenz statt. Stattdessen kann das Ersatzschaltbild während des Onboardings übertragen und auf dem IIOT-Gerät gespeichert werden.

In einem Schritt E wird anhand des Schlupfs s, der Synchronfrequenz f₁ und des bereitgestellten Ersatzschaltbildes (der ermittelten Ersatzschaltbildparameterwerte) Betriebsverhalten der Maschine 2 und insbesondere ihr Betriebspunkt ermittelt.

Die Schritte A bis C und E können allesamt beispielsweise mittels des IoT-Geräts 10 ausgeführt werden.

Denkbar ist aber auch, dass das IoT-Gerät 10 lediglich einen oder mehrere der Schritte A bis C durchführt und die restlichen Schritte durch eine andere Recheneinheit, z.B. einen lokalen Server oder durch den Backend-Server 5 durchgeführt werden. Beispielsweise kann das IoT-Gerät 10 Streumagnetfelddaten an diese Recheneinheit zur Weiterverarbeitung und Analyse übermitteln.

Somit kann eine Anordnung zur Betriebsverhaltensermittlung einer an einer Betriebsspannung angeschlossenen elektrischen rotatorischen Maschine 2 eine Sensorvorrichtung 10 und eine Recheneinrichtung umfassen, die derart konfiguriert sind und zusammenwirken, dass die Schritte A bis E des Verfahrens ausgeführt werden. Die Recheneinrichtung kann beispielsweise den Backend-Server 5, das mobile Gerät 6, die Datenbank 8 und die Anzeigevorrichtung 12 umfassen (siehe FIG 6).

Obwohl die Erfindung im Detail durch Ausführungsbeispiele näher illustriert und beschrieben wurde, ist die Erfindung nicht durch die offenbarten Beispiele eingeschränkt. Variationen hiervon können vom Fachmann abgeleitet werden, ohne den Schutzumfang der Erfindung, wie er durch die nachfolgenden Patentansprüche definiert wird, zu verlassen. Insbesondere können das beschriebene Verfahren zum Bereitstellen eines Ersatzschaltbildes durch Merkmale verbessert werden, die in Bezug auf das Verfahren zum Bereitstellen einer trainierten Funktion beschrieben oder beansprucht wurden und *vice versa.* Dies findet *mutatis mutandis* Anwendung auf das Verfahren zum Anbinden von einer elektrischen rotatorischen Maschine an eine Plattform, das Verfahren zur Betriebsverhaltensermittlung einer an einer Betriebsspannung angeschlossenen elektrischen rotatorischen Maschine und auf die Anordnung zur Betriebsverhaltensermittlung einer an einer Betriebsspannung angeschlossenen elektrischen rotatorischen Maschine.

## Patentansprüche

1. Verfahren zum Anbinden von einer elektrischen rotatorischen Maschine (2) an eine Plattform (3), **dadurch gekennzeichnet, dass**
- anhand der Maschine (2) in einem nicht an einer Betriebsspannung angeschlossenen Zustand Inputdaten erhoben werden, die eine Achshöhe, eine Polpaarzahl und Leistungsschildangaben (LSA) der Maschine (2) umfassen, wobei die Inputdaten für die Maschine (2) charakteristisch sind und als Input für eine Konfigurationsanwendungssoftware eingegeben werden, wobei
- die Konfigurationsanwendungssoftware die Inputdaten an die Plattform (3) überträgt, wobei die Plattform (3) ein Simulationsmodell der elektrischen rotatorischen Maschine (2) bereitstellt, wobei die Plattform (3):
* Inputdaten erhält (S1),
* aus den Inputdaten unter Zuhilfenahme einer trainierten Funktion (F) das Simulationsmodell festlegende Parameterwerte ermittelt (S2),
wobei die trainierte Funktion (F) mittels Trainingsinput- und Trainingsoutputdaten trainiert wurde,
wobei die Trainingsinputdaten für elektrische rotatorische Maschinen charakteristisch sind, anhand der Maschinen in einem nicht an einer Betriebsspannung angeschlossenen Zustand erhebbar sind, und Achshöhen und Polpaarzahlen der Maschinen umfassen,
wobei die Trainingsoutputdaten Verlust- und Streukoeffizienten der Maschinen umfassen und für Parameterwerte repräsentativ sind, die Simulationsmodelle von den elektrischen rotatorischen Maschinen festlegen,
wobei die trainierte Funktion (F) basierend auf der Achshöhe und der Polpaarzahl Verlust- und Streukoeffizienten der elektrischen rotatorischen Maschine (2) ermittelt (S20)
wobei die Parameterwerte aus den ermittelten Verlust- und Streukoeffizienten und den Leistungsschildangaben (LSA) ermittelt werden.

2. Verfahren nach Anspruch 1, wobei das Simulationsmodell an die Konfigurationsanwendungssoftware übermittelt wird, wobei die Konfigurationsanwendungssoftware das Simulationsmodell an eine an der Maschine (2) angeordnete, vorzugsweise befestigte Sensorvorrichtung (10) überträgt.

3. Verfahren nach Anspruch 1 oder 2, wobei die Plattform (3) eine Software-Plattform ist.

4. Verfahren nach einem der Ansprüche 1 bis 3, wobei die Plattform (3) eine Cloud-Plattform ist.

5. Verfahren nach einem der Ansprüche 1 bis 4, wobei die trainierte Funktion auf einem neuronalen Netz, auf einer Regression basiert ist.

6. Verfahren nach Anspruch 5, wobei die Funktion auf einer multivariaten Regression basiert ist.

7. Verfahren nach einem der Ansprüche 1 bis 6, wobei ein Trainingsdatensatz, der Trainingsinput- und Trainingsoutputdaten umfasst, vorverarbeitet wird, bevor die Funktion auf dem Trainingsdatensatz trainiert wird.

8. Verfahren nach Anspruch 7, wobei die Vorverarbeitung ein Bringen der Daten in eine relative und normierte Form umfasst.

9. Verfahren nach einem der Ansprüche 1 bis 8, wobei die Inputdaten einer Plausibilitätsprüfung unterzogen werden.

10. Verfahren nach einem der Ansprüche 1 bis 9, wobei das Simulationsmodell als ein Ersatzschaltbild ausgestaltet ist.

11. Verfahren nach Anspruch 10, wobei das Ersatzschaltbild ein erweitertes Ersatzschaltbild ist.

12. Verfahren zur Betriebsverhaltensermittlung einer an einer Betriebsspannung angeschlossenen elektrischen rotatorischen Maschine (2), wobei
A) die elektrische rotatorische Maschine (2) an eine Plattform (3) gemäß einem Verfahren nach einem der Ansprüche 1 bis 11 angebunden wird,
B) ein Streumagnetfeld außerhalb der Maschine (2) erfasst wird,
C) aus dem erfassten Streumagnetfeld eine Schlupffrequenz und eine Synchronfrequenz berechnet werden,
D) aus der Schlupffrequenz und der Synchronfrequenz ein Schlupf berechnet wird,
E) anhand des Schlupfs, der Synchronfrequenz und des von der Plattform (3) bereitgestellten Simulationsmodells das Betriebsverhalten der Maschine (2) ermittelt wird.

13. Verfahren nach Anspruch 12, wobei anhand des Schlupfs, der Synchronfrequenz und des Simulationsmodelles ein Betriebspunkt der Maschine ermittelt wird.

14. Anordnung zur Betriebsverhaltensermittlung einer an einer Betriebsspannung angeschlossenen elektrischen rotatorischen Maschine (2), wobei die Anordnung eine Sensorvorrichtung (10) und eine Recheneinrichtung (5, 6, 8, 12) umfasst, **dadurch gekennzeichnet, dass** die Sensorvorrichtung (10) dazu ausgebildet ist, ein Streumagnetfeld außerhalb der Maschine (2) zu erfassen und aus dem erfassten Streumagnetfeld eine Schlupffrequenz und eine Synchronfrequenz zu berechnen und diese an die Recheneinrichtung (5, 6, 8, 12) zu übermitteln, wobei auf der Recheneinrichtung (5, 6, 8, 12) ein Simulationsmodell (EC1, EC2, EC3) der elektrischen rotatorischen Maschine (2) gespeichert ist, wobei das Simulationsmodell von einem Computerprogramm bereitgestellt wurde, wobei das Computerprogramm
* Inputdaten erhält (S1),
* aus den Inputdaten unter Zuhilfenahme einer trainierten Funktion (F) das Simulationsmodell festlegende Parameterwerte ermittelt (S2),
wobei die trainierte Funktion (F) mittels Trainingsinput- und Trainingsoutputdaten trainiert wurde,
wobei die Trainingsinputdaten für elektrische rotatorische Maschinen charakteristisch sind, anhand der Maschinen in einem nicht an einer Betriebsspannung angeschlossenen Zustand erhebbar sind, und Achshöhen und Polpaarzahlen der Maschinen umfassen,
wobei die Trainingsoutputdaten Verlust- und Streukoeffizienten der Maschinen umfassen und für Parameterwerte repräsentativ sind, die Simulationsmodelle von den elektrischen rotatorischen Maschinen festlegen,
wobei die trainierte Funktion (F) basierend auf der Achshöhe und der Polpaarzahl Verlust- und Streukoeffizienten der elektrischen rotatorischen Maschine (2) ermittelt (S20), wobei die Parameterwerte aus den ermittelten Verlust- und Streukoeffizienten und den Leistungsschildangaben (LSA) ermittelt werden,
und die Recheneinrichtung (5, 6, 8, 12) dazu konfiguriert ist, anhand der berechneten Schlupf- und Synchronfrequenz einen Schlupf und anschließend mittels des von dem Computerprogramm bereitgestellten Simulationsmodelles (EC1, EC2, EC3) das Betriebsverhalten der Maschine (2) zu ermitteln.

## Claims

1. Method for linkage of an electric rotating machine (2) to a platform (3), **characterised in that**
- input data is collected using the machine (2) in a state not connected to an operating voltage, said input data comprising a shaft height, a number of pole pairs and rating plate specifications (LSA) of the machine (2), wherein the input data is characteristic of the machine (2) and is entered as input for configuration application software, wherein
- the configuration application software transmits the input data to the platform (3), wherein the platform (3) provides a simulation model of the electric rotating machine (2), wherein the platform (3):
* obtains input data (S1),
* determines (S2) parameter values defining the simulation model from the input data with the help of a trained function (F),
wherein the trained function (F) was trained by means of training input and training output data,
wherein the training input data is characteristic of electric rotating machines, can be collected using the machines in a state which is not connected to an operating voltage and comprises shaft heights and number of pole pairs of the machines,
wherein the training output data comprises loss and stray coefficients of the machines and are representative of parameter values, which define simulation models of the electric rotating machines,
wherein based on the shaft height and the number of pole pairs, the trained function (F) determines (S20) loss and stray coefficients of the electric rotating machine (2) wherein the parameter values are determined from the determined loss and stray coefficients and the rating shield specifications (LSA).

2. Method according to claim 1, wherein the simulation model is transferred to the configuration application software, wherein the configuration application software transmits the simulation model to a sensor apparatus (10) arranged on the machine (2), preferably fastened to it.

3. Method according to claim 1 or 2, wherein the platform (3) is a software platform.

4. Method according to one of claims 1 to 3, wherein the platform (3) is a Cloud platform.

5. Method according to one of claims 1 to 4, wherein the trained function is based on a neural network, on a regression.

6. Method according to claim 5, wherein the function is based on a multivariate regression.

7. Method according to one of claims 1 to 6, wherein a training dataset, which comprises training input and training output data, is preprocessed before the function is trained on the training dataset.

8. Method according to claim 7, wherein the preprocessing comprises bringing the data into a relative and normalised form.

9. Method according to one of claims 1 to 8, wherein the input data is subjected to a plausibility check.

10. Method according to one of claims 1 to 9, wherein the simulation model is arranged as an equivalent circuit diagram.

11. Method according to claim 10, wherein the equivalent circuit diagram is an expanded equivalent circuit diagram.

12. Method for determining the operating behaviour of an electric rotating machine (2) connected to an operating voltage, wherein
A) the electric rotating machine (2) is linked to a platform (3) according to a method according to one of claims 1 to 11,
B) a stray magnetic field is captured outside of the machine (2),
C) a slip frequency and a synchronous frequency are calculated from the detected stray magnetic field,
D) a slip is calculated from the slip frequency and the synchronous frequency,
E) using the slip, the synchronous frequency and the simulation model provided by the platform (3), the operating behaviour of the machine (2) is determined.

13. Method according to claim 12, wherein an operating point of the machine is determined on the basis of the slip, the synchronous frequency and the simulation model.

14. Arrangement for determining the operating behaviour of an electric rotating machine (2) connected to an operating voltage, wherein the arrangement comprises a sensor apparatus (10) and a processing facility (5, 6, 8, 12),
**characterised in that**
the sensor apparatus (10) is embodied to detect a stray magnetic field outside of the machine (2) and to calculate a slip frequency and a synchronous frequency from the detected stray magnetic field and to transfer this to the processing facility (5, 6, 8, 12), wherein
a simulation model (EC1, EC2, EC3) of the electric rotating machine (2) is stored on the processing facility (5, 6, 8, 12), wherein the simulation model was provided by a computer program, wherein the computer program
* obtains input data (S1),
* determines parameter values (S2) defining the simulation model from the input data with the help of a trained function (F),
wherein the trained function (F) was trained by means of training input and training output data,
wherein the training input data is characteristic of electric rotating machines, can be collected using the machines in a state which is not connected to an operating voltage and comprises shaft heights and numbers of pole pairs of the machines,
wherein the training output data comprises loss and stray coefficients of the machines and is representative of parameter values which define simulation models of the electric rotating machines,
wherein the trained function (F) determines (S20) loss and stray coefficients of the electric rotating machines (2) on the basis of the shaft height and the number of pole pairs, wherein the parameter values are determined from the determined loss and stray coefficients and the rating plate specifications (LSA),
and the processing facility (5 ,6, 8, 12) is configured to determine a slip and then by means of the simulation model (EC1, EC2, EC3) provided by the computer program the operating behaviour of the machine (2) using the calculated slip and synchronous frequency.

## Revendications

1. Procédé de liaison d'une machine (2) électrique rotative à une plateforme (3), **caractérisé en ce qu'**
- à l'aide de la machine (2) dans un état connecté à une tension de fonctionnement, on recueille des données d'entrée, qui comprennent une hauteur d'axe, un nombre de paires de pôles et des indications (LSA) de plaques signalétiques de la machine (2), dans lequel les données d'entrée sont caractéristiques pour la machine (2) et on les entre comme entrée pour un logiciel d'application de configuration, dans lequel
- le logiciel d'application de configuration transmet les données d'entrée à la plateforme (3), dans lequel la plateforme (3) met à disposition un modèle de simulation de la machine (2) électrique rotative, dans lequel la plateforme (3) :
* reçoit (S1) des données d'entrée,
* détermine (S2), à partir des données d'entrée, en s'aidant d'une fonction (F) d'apprentissage, des valeurs de paramètre fixant le modèle de simulation,
dans lequel on a fait l'apprentissage de la fonction (F) d'apprentissage au moyen d'entrées d'apprentissage et de données de sortie d'apprentissage,
dans lequel les données d'entrée d'apprentissage sont caractéristiques pour des machines électriques rotatives, peuvent être relevées à l'aide des machines dans un état non connecté à une tension de fonctionnement et comprennent des hauteurs d'axe et des nombres de paires de pôles des machines,
dans lequel les données de sortie d'apprentissage comprennent des coefficients de perte et de dispersion des machines et sont représentatives de valeurs de paramètre, qui fixent des modèles de simulation des machines électriques rotatives,
dans lequel la fonction (F) d'apprentissage détermine (S20) sur la base de la hauteur d'axe et du nombre de paires de pôles, des coefficients de perte et de dispersion de la machine (2) électrique rotative,
dans lequel on détermine les valeurs de paramètres à partir des coefficients déterminés de perte et de dispersion et des indications (LSA) de plaque signalétique.

2. Procédé suivant la revendication 1, dans lequel on transmet le modèle de simulation au logiciel d'application de configuration, dans lequel le logiciel d'application de configuration transmet le modèle de simulation à un dispositif (10) capteur monté sur la machine (2) en y étant, de préférence, fixé.

3. Procédé suivant la revendication 1 ou 2, dans lequel la plateforme (3) est une plateforme de logiciel.

4. Procédé suivant l'une des revendications 1 à 3, dans lequel la plateforme (3) est une plateforme de nuage.

5. Procédé suivant l'une des revendications 1 à 4, dans lequel la fonction d'apprentissage sur un réseau neuronal repose sur une régression.

6. Procédé suivant la revendication 5, dans lequel la fonction repose sur une régression à variables multiples.

7. Procédé suivant l'une des revendications 1 à 6, dans lequel on prétraite un ensemble de données d'apprentissage, qui comprend des données d'entrée d'apprentissage et des données de sortie d'apprentissage, avant de faire l'apprentissage de la fonction sur l'ensemble de données d'apprentissage.

8. Procédé suivant la revendication 7, dans lequel le prétraitement comprend une mise des données dans une forme relative et normée.

9. Procédé suivant l'une des revendications 1 à 8, dans lequel on soumet les données d'entrée à un contrôle de vraisemblance.

10. Procédé suivant l'une des revendications 1 à 9, dans lequel le modèle de simulation est conformé en un schéma de remplacement.

11. Procédé suivant la revendication 10, dans lequel le schéma de remplacement est un schéma de remplacement agrandi.

12. Procédé de détermination du comportement de fonctionnement d'une machine (2) électrique rotative connectée à une tension de fonctionnement, dans lequel
A) on relie la machine (2) électrique rotative à une plateforme (3) selon un procédé suivant l'une des revendications 1 à 11,
B) on détecte un champ magnétique de dispersion à l'extérieur de la machine (2),
C) à partir du champ magnétique de dispersion détecté, on calcule une fréquence de glissement et une fréquence synchrone,
D) on calcule un glissement à partir de la fréquence de glissement et de la fréquence synchrone,
E) à l'aide du glissement, de la fréquence synchrone et du modèle de simulation mis à disposition par la plateforme (3), on détermine le comportement de fonctionnement de la machine (2).

13. Procédé suivant la revendication 12, dans lequel, à l'aide du glissement de la fréquence synchrone et du modèle de simulation, on détermine un point de fonctionnement de la machine.

14. Agencement de détermination du comportement de fonctionnement d'une machine (2) électrique rotative connectée à une tension de fonctionnement, dans lequel l'agencement comprend un dispositif (10) capteur et un dispositif (5, 6, 8, 12) informatique, **caractérisé en ce que**
le dispositif (10) capteur est constitué pour détecter un champ magnétique de dispersion à l'extérieur de la machine (2) et pour calculer, à partir du champ magnétique de dispersion détecté, une fréquence de glissement et une fréquence synchrone et les transmettre au dispositif (5, 6, 8, 12) informatique, dans lequel il est mis en mémoire, sur le dispositif (5, 6, 8, 12) informatique, un modèle (EC1, EC2, EC3) de simulation de la machine (2) électrique rotative, dans lequel le modèle de simulation a été mis à disposition par un programme d'ordinateur, dans lequel le programme d'ordinateur
* reçoit (S1) des données d'entrée,
* détermine (S2), à partir des données d'entrée en s'aidant d'une fonction (F) d'apprentissage, des valeurs de paramètre fixant le modèle de simulation,
dans lequel on a fait l'apprentissage de la fonction (F) d'apprentissage au moyen d'entrées d'apprentissage et de données de sortie d'apprentissage,
dans lequel les données d'entrée d'apprentissage sont caractéristiques pour des machines électriques rotatives, peuvent être relevées à l'aide des machines dans un état non connecté à une tension de fonctionnement et comprennent des hauteurs d'axe et des nombres de paires de pôles des machines,
dans lequel les données de sortie d'apprentissage comprennent des coefficients de perte et de dispersion des machines et sont représentatives de valeurs de paramètres, qui fixent des modèles de simulation des machines électriques rotatives,
dans lequel la fonction (F) d'apprentissage détermine (S20) sur la base de la hauteur d'axe et du nombre de paires de pôles, des coefficients de perte et de dispersion de la machine (2) électrique rotative, dans lequel on détermine les valeurs de paramètre à partir des coefficients déterminés de perte et de dispersion et des indications (LSA) de plaque signalétique,
et le dispositif (5, 6, 8, 12) informatique est configuré pour, à l'aide de la fréquence de glissement calculée et de la fréquence synchrone, déterminer un glissement et ensuite pour, au moyen du modèle (EC1, EC2, EC3) de simulation mis à disposition par le programme d'ordinateur, déterminer le comportement de fonctionnement de la machine (2).
